# EUROPEAN PATENT APPLICATION

(11) **EP 0 803 903 A2**
(43) Date of publication of application: **29.10.1997**
(21) Application number: 97106821.8
(22) Date of filing: 24.04.1997
(51) Int. Cl.: H01L 21/66

(54) **Automatic visual inspection and failure categorization system**

(30) Priority: 25.04.1996 JP 105248/96
(71) Applicant: NEC CORPORATION, Tokyo (JP)
(72) Inventor: Kawabe, Shinya, Kusunokicho, Asa-gun, Yamaguchi (JP)
(74) Representative: Glawe, Delfs, Moll & Partner

(57) **Abstract**

An automatic visual inspection system causes a light beam (LB10) to sweep an area of a semiconductor wafer (WF) for producing pieces of image data, checks the pieces of image data to see whether or not a defect is incorporated in an layout in the area, and the automatic visual inspection system not only determines the location of the defect but also categorizes the defect in one of defect modes so as to complete the visual inspection within short time.

## Description

### FIELD OF THE INVENTION

This invention relates to a semiconductor fabrication technology and, more particularly, to an automatic visual inspection system for a layout on a surface of a semiconductor wafer.

### DESCRIPTION OF THE RELATED ART

An integrated circuit device is fabricated on small areas of a semiconductor wafer through a growing a deposition, a lithography, an etching and so forth. Upon completion of the integrated circuit, various tests are carried out to see whether or not the integrated circuit is defective. One of the tests is known as "visual inspection", and an automatic visual inspection system is usually used for the visual inspection. The automatic visual inspection system diagnoses the appearance of each area at high speed, and is reliable.

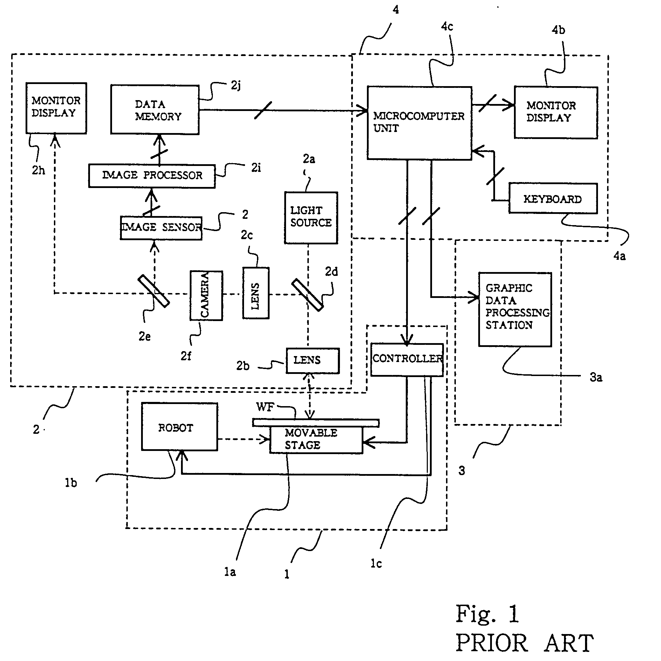

Figure 1 illustrates a typical example of the automatic visual inspection system. The prior art automatic visual inspection system largely comprises a loading sub-system 1, a defect detecting sub-system 2, a data analyzing sub-system 3 and a controlling sub-system 4. A loading sub-system 1 aligns a semiconductor wafer WF with the defect detecting sub-system 2, and the defect detecting sub-system 2 optically checks the surface of the semiconductor wafer WF to see whether or not a defect is found under the control of a controlling sub-system 4. When the defect is found, the defect detecting sub-system 2 produces positional data indicative of the defect, and the analyzing sub-system 3 graphically processes the positional data so as to provide a graph and/or a wafer map.

The loading sub-system includes a movable stage 1a, a conveying robot 1b and a controller 1c. The movable stage 1a is two-dimensionally movable, and the conveying robot 1b mounts the semiconductor wafer WF on the movable stage 1a. The movable stage 1a and the conveying robot 1b are under the control of the controlling sub-system 4, and make the defect detecting sub-system 2 to search the surface of the semiconductor wafer WF for a defect.

The defect detecting sub-system 2 includes a light source 2a, lens units 2b/2c, half mirrors 2d/2e, a color camera 2f, an image sensor 2g, a monitor display 2h, an image processor 2i and a data memory 2j. The light source radiates a light beam through the half-mirror 2d and the lens unit 2b to the semiconductor wafer WF on the movable stage 1a. The light beam is reflected from the surface of the semiconductor wafer WF as an image carrying light, and the movable stage 1a sequentially changes the relative position between the light beam and the semiconductor wafer WF. When the movable stage 1a causes the light beam to sweep a predetermined area of the upper surface of the semiconductor wafer WF under the control of the controlling sub-system 4, the image carrying light brings a pattern on the upper surface of the semiconductor wafer WF to the color camera through the half mirror 2d and the lens unit 2c.

The color camera 2f picks up the pattern image from the image carrying light, and the image sensor 2g converts the pattern image to a set of image data. The set of image data are supplied to the image processor 2i, and the image processor 2g processes the set of image data on the basis of an inspection file, which contains thresholds of gray level, so as to produce a set of gradation data representative of a distribution of gray level. The image processor checks the set of gradation data to see whether the distribution of gray level is regular or irregular. If the distribution is irregular, the image processor 2i decides the layout to have a defect, and determines the coordinates of the defect in a suitable coordinate system. The image processor 2i determines the size of the defect on the basis of the pixels occupied by the defect. The image processor 2i supplies coordinate data representative of the position of the defect to the data memory 2j, and the coordinate data are stored in the data memory 2j.

The controlling sub-system 4 includes a keyboard 4a manipulated by an operator, a monitor display 4b for communicating with the operator and a microcomputer unit 4c connected to the data memory 2j, the keyboard 4a, the controller 1c, the monitor display 4b and the analyzing sub-system 3. The analyzing sub-system 3 is implemented by a graphic data processing station 3a, and the graphic data processing station 3a is also connected to the microcomputer unit 4c.

Upon completion of the sweep over the predetermined area, the microcomputer unit 4c requests the data memory 2j to transfer the coordinate data representative of the defect thereto, and the microcomputer unit 4c instructs the controller 1c to align the light beam with the defect on the upper surface of the semiconductor wafer WF. The image of the defect is transferred from the color camera 2f through the half mirror 2e to the monitor display 2h, and the monitor display 2h allows the operator to observe the defect.

The defect is categorized into one of defect modes, and the operator specifies one of the defect modes for the defect. When the operator decides the defect mode, the operator inputs the defect mode from the keyboard 4a. The operator further instructs the microcomputer unit 4c to transfer a data code representative of the defect mode through a menu produced on the monitor display 4b. Then, the microcomputer unit 4c transfers the data code representative of the defect mode to the graphic data processing station 3a, and the graphic data processing station 3a produces a graph and/or a wafer map for the defect. The behavior of the microcomputer unit 4c is disclosed in Japanese Patent Publication of Unexamined Application No. 3-57241.

Thus, the prior art automatic visual inspection system only discriminates a defect or defects in the layout on the upper surface of the semiconductor wafer WF, and an operator categorizes the defect or defects on the basis of the image reproduced on the monitor display 2h. Such a categorizing work consumes a large amount of time.

Another problem is inaccurate decision on the defect size. As described hereinbefore, the image processor 2i decides the defect size on the basis of how many pixels the defect occupies on the screen. This means that the defect size is represented by a multiple of the pixel size. However, the pixel is not so small that an error takes place between the magnitude of defect determined by the image processor 2i and the actual defect.

### SUMMARY OF THE INVENTION

It is therefore an important object of the present invention to provide an automatic visual inspection system which not only discriminates a defect of a semiconductor device but also categorizes the defect into one of defect modes.

To accomplish the object, the present invention proposes to compare a part of a distribution of gray level with variations of gray level representative of different kinds of defect so as to automatically categorize the defect.

In accordance with the present invention, there is provided an automatic visual inspection system for visually inspecting an appearance of a target layer comprising: an image data generating/processing sub-system radiating a light beam for sweeping the target layer for producing pieces of image data representative of the appearance, determining a location of a defect contained in the target layer, and categorizing the defect to one of defect modes; and a controlling sub-system connected to the image data generating/processing sub-system, causing the light beam radiated from the controlling sub-system to sweep the target layer, and providing pieces of defect information representative of the location of the defect and the aforesaid one of the defect modes to an operator.

### BRIEF DESCRIPTION OF THE DRAWINGS

The features and advantages of the automatic visual inspection system according to the present invention will be more clearly understood from the following description taken in conjunction with the accompanying drawings in which:
Fig. 1 is a block diagram showing the arrangement of the prior art automatic visual inspection system;
Fig. 2 is a block diagram showing the arrangement of an automatic visual inspection system;
Fig. 3 is a flow chart showing an inspection sequence carried out by the automatic visual inspection system;
Fig. 4A is a plan view showing an excellent wiring pattern to be visually inspected by the automatic visual inspection system;
Fig. 4B is a graph showing a variation of gray level representative of the excellent wiring pattern;
Fig. 5A is a plan view showing a defective wiring pattern to be visually inspected by the automatic visual inspection system;
Fig. 5B is a graph showing a variation of gray level representative of the defective wiring pattern; and
Fig. 6 is a block diagram showing the arrangement of another automatic visual inspection system according to the present invention.

### DESCRIPTION OF THE PREFERRED EMBODIMENTS

### First Embodiment

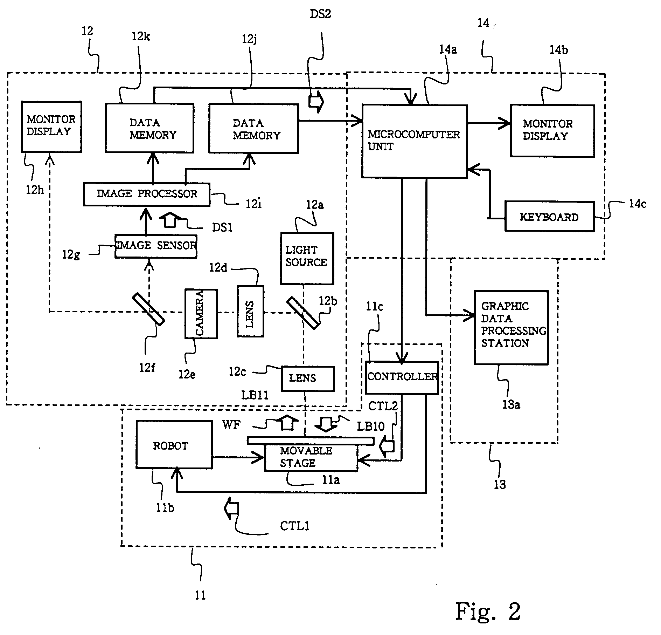

Referring to figure 2 of the drawings, an automatic visual inspection system embodying the present invention largely comprises a loading sub-system 11, an image data generating/processing sub-system 12, a data analyzing sub-system 13 and a controlling sub-system 14.

A loading sub-system 11 aligns a semiconductor wafer WF with the image data generating/processing sub-system 12 under the control of the controlling sub-system 14. The image data generating/processing sub-system 12 acquires image data of a predetermined area on an upper surface of the semiconductor wafer WF through a sweeping operation over the predetermined area with a light beam LB10, and determines the location of a defect in the layout, the size of the defect and a defect mode to which the defect belongs. Positional data representative of the location, magnitude data representative of the size, category data representative of the defect mode are temporarily stored therein.

The analyzing sub-system 13 graphically processes positional data representative of the location of the defect and category data representative of the defect mode, and provides a graph and/or a wafer map.

The controlling sub-system 14 moves the semiconductor wafer WF to a detectable position, and causes the image data generating/processing sub-system 12 to sweep the predetermined area with the light beam LB10. The controlling sub-system 14 is further operative to transfer the positional data, the magnitude data and the category data from the image data generating/processing sub-system 12 to the analyzing sub-system 13. The loading sub-system 11, the image data generating/ processing sub-system 12, the data analyzing sub-system 13 and the controlling sub-system 14 are detailed as follows.

The loading sub-system 11 includes a movable stage 11a, a conveying robot 11b and controller 11c. The movable stage 11a has an upper surface where a semiconductor wafer WF is mounted, and is two-dimensionally movable. The conveying robot 11b is provided between a stock yard (not shown) for semiconductor wafers WF and the movable stage 11a, and conveys a semiconductor wafer from the stock yard onto the upper surface of the movable stage 11a.

The controller 11c is responsive to instructions supplied from the controlling sub-system 14 so as to control the robot 11b and the movable stage 11a. When the controlling sub-system 14 instructs the controller 11c to mount a semiconductor wafer WF on the movable stage 11a, the controller 11c supplies control signals CTL1 to the conveying robot 11b, and the conveying robot 11b conveys a semiconductor wafer WF from a stock yard (not shown) onto the movable stage 11a. The controlling sub-system 14 further instructs the controller 11c to cause the image data generating/processing sub-system 12 to sweep the predetermined area with the light beam LB10, and the controller 11c sequentially changes control signals CTL2 so as to move the movable stage 11a along a predetermined loop. On the other hand, when the controlling sub-system 14 instructs the controller 11c to align a defect with the image data generating/processing sub-system 12, the controller 11c supplies the control signals CTL2 indicative of the location of the defect to the movable stage 11a, and the movable stage 11a align the location with the light beam LB10.

The image data generating/processing sub-system 12 includes a light source 12a, a half mirror 12b and lens units 12c/12d. The lens unit 12c is provided between the light source 12a and the movable stage 11a, and the half mirror 12b is provided between the light source 12a and the lens unit 12c. The light source 12a radiates the light beam LB10 through the half mirror 12b to the lens unit 12c, and the lens unit 12c focuses the light beam LB10 onto the predetermined area. The light beam LB10 is reflected on the predetermined area, and a reflected light beam LB11 is bent on the half mirror 12b toward the lens unit 12d. The reflected light beam LB11 carries an image of a part of a layout in the predetermined area.

The image data generating/processing sub-system 12 further includes a color camera 12e, a half mirror 12f, an image sensor 12g and a monitor display 12h. The color camera 12e picks up the image from the reflected light beam LB11, and the half mirror 12f supplies the image to both of the image sensor 12g and the monitor display 12h. The monitor display 12h magnifies the image, and produces the image on the screen. The image sensor 12g converts the image to a digital data signal DS1 representative of image data for the image.

The image data generating/processing sub-system 12 further includes an image processor 12i and data memories 12j/12k. The image processor 12i sequentially compares pieces of the image data with thresholds stored in an inspection file for the semiconductor wafer WF on the movable stage 11a, and produces a distribution of gray level. The image processor 12i checks the distribution of gray level to see whether or not a defect or defects are found in the layout in the predetermined area. If a defect is found, the image processor 12i gives coordinates in a certain coordinate system, and determines the magnitude of the defect. The image processor 12i categorizes the defect into one of the defect modes, and memorizes a piece of positional data representative of the location of the defect/ a piece of magnitude data representative of the magnitude of the defect and a piece of category data representative of the defect mode in the data memories 12j and 12k, respectively.

The categorizing operation is carried out as follows. The inspection file contains not only the thresholds but also defect patterns or variations of gray level respectively representative of the defect modes. The image processor 12i compares the distribution of gray level with the defect patterns. If a part of the distribution of gray level is matched with one of the defect patterns, the image processor 12i decides the part of the distribution to be a defect, and categorizes the defect to the defect mode represented by the variation of gray level.

The data analyzing sub-system 13 includes a graphic data processing station 13a, and the graphic data processing station 13a analyzes the positional data, the magnitude data and the category data so as to produce a graph and/or a wafer map.

The controlling sub-system 14 includes a microcomputer unit 14a, a monitor display 14b connected to the microcomputer unit 14a and a keyboard 14c connected to the microcomputer unit 14a. An operator provides various instructions to the microcomputer unit 14a through the keyboard 14c, and confirms the operation on the monitor display 14b.

The microcomputer unit 14a is responsive to the selected instruction, and controls the loading sub-system 11, the image data generating/processing sub-system 12 and the analyzing sub-system 13 for producing the positional data, the category data and the magnitude data.

When an operator requests the microcomputer unit 14a to form a new inspection file, the microcomputer unit 14a edits manufacturer's data so as to produce a new inspection file for a new kind of semiconductor wafer WF. The operator can move the movable stage 11a through the keyboard 14c.

The microcomputer unit 14a further carries out a data transfer between the data memories 12j/12k and the graphic data processing station 13a, and the graph and/or wafer map is produced on the screen of the monitor display 14b.

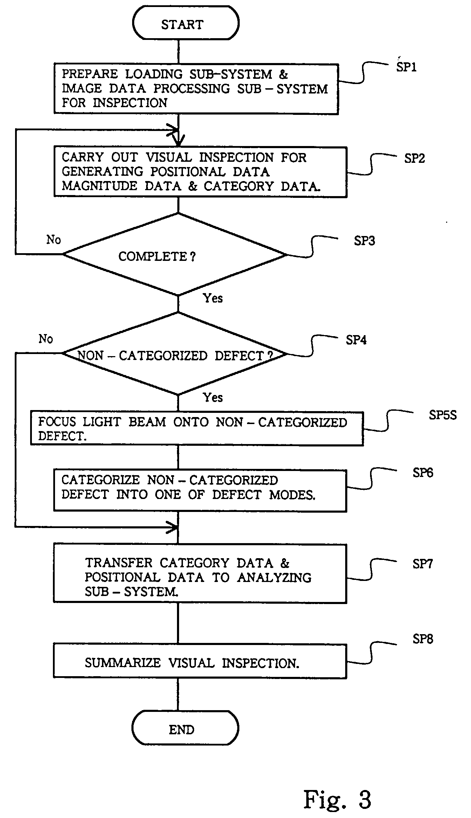

Subsequently, description is made on an inspection sequence with reference to figure 3 of the drawings.

The inspection sequence starts with an instruction of an operator through the keyboard 14c. The microcomputer 14a instructs the loading sub-system 11 and the image data generating/processing sub-system 12 to cooperate with each other. The conveying robot 11b places a new semiconductor wafer WF on the movable stage 11a, and the light source 12a, the half mirror 12b and the lens unit 12c project the light beam LB10 onto the upper surface of the semiconductor wafer WF. The operator moves the movable stage 11a through the keyboard 14c, and specifies the predetermined area. Thus, the microcomputer unit 14a prepares the loading sub-system 11 and the image data generating/processing sub-system 12 for the visual inspection as by step SP1.

While the movable stage 11a is changing the light spot of the beam LB10 over the predetermined area, the image sensor 12g sequentially produces the digital data signal DS1 representative of pieces of image data, and the image processor 12i produces the pieces of positional data representative of the coordinates of defects, the pieces of magnitude data representative of the size of the defects and the pieces of category data representative of the defect modes of the defects as by step SP2. The pieces of positional data, the pieces of magnitude data and the pieces of category data are stored in the data memories 12j/12k.

While the light beam LB10 is sweeping the predetermined area, the answer at step SP3 is given negative, and the image processor 12i continues the data processing. However, upon completion of the sweeping operation, the answer at step SP3 is changed to affirmative, and the microcomputer unit 14a checks the data memory 12k to see whether or not there is a defect not categorized yet.

If the answer at step SP4 is given affirmative, the microcomputer unit 14a fetches the positional data for the non-categorized defect, and instructs the loading sub-system 11 and the image data generating/processing sub-system 12 to focus the light beam LB10 onto the non-categorized defect as by step SP5.

The non-categorized defect is projected onto the screen of the monitor display 12h, and the operator categorizes one of the defect modes through the keyboard 14c as by step SP6. The variation of gray level for the non-categorized defect is added to the inspection file, and the image processor 12i is allowed to automatically categorize the sake kind of defect.

Upon completion of the categorizing operation through the keyboard 14c, the microcomputer unit 14a proceeds to step SP7. When the answer at step SP4 is given negative, the microcomputer unit 14a directly proceeds to step SP7 without execution of steps 5 and 6. The microcomputer unit 14a transfers the pieces of category data paired with the pieces of locational data to the analyzing sub-system 13 at step SP7, and the graphic data processing station 13a summarizes the visual inspection as by step SP8. The summary of the visual inspection is transferred to the microcomputer unit 14a, and the microcomputer unit 14a provides the summary to the operator.

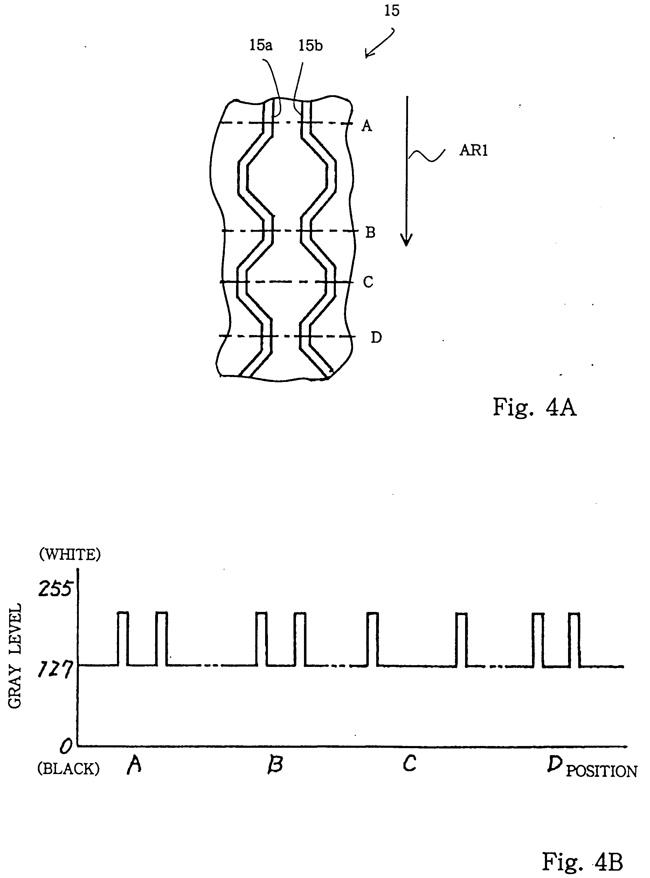

Assuming now that a wiring pattern 15a is formed in the predetermined area, a pair of wiring strips 15a/15b extend in such a manner that the gap therebetween is periodically changed. While the light beam LB10 is sweeping in a direction indicated by arrow AR1, the gray level is changed as shown in figure 4B. The gray level is periodically changed over "127" in proportional to the gap, and the peaks of gray level are equal in width to one another.

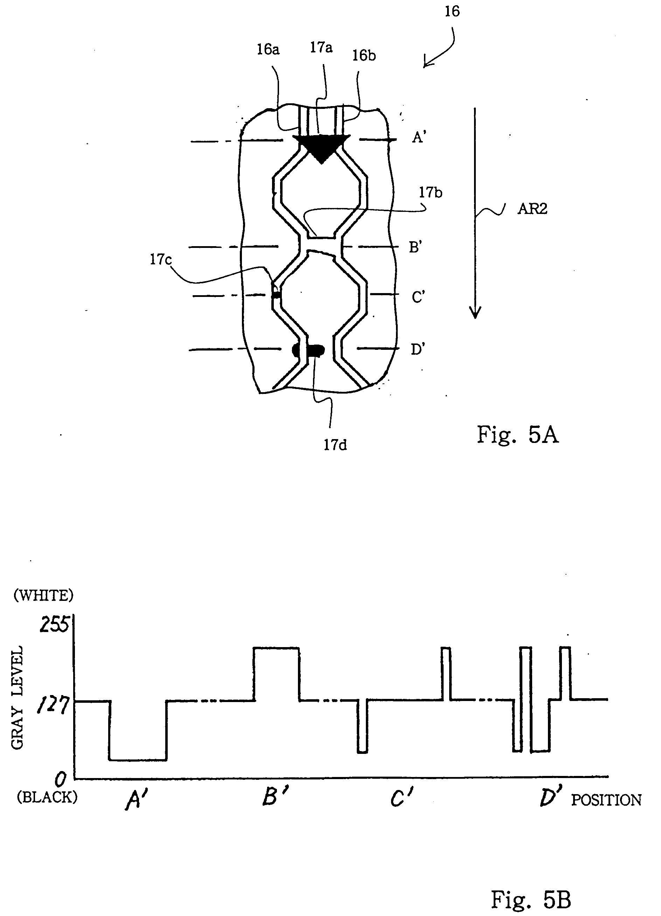

If several defects take place in a wiring pattern 16 identical with the wiring pattern 15 as shown in figure 5A, the distribution of gray level is different from that of the excellent wiring patter 15 as shown in figure 5B.

The defect at position A' is a dust particle 17a attached to the upper surfaces of the wiring strips 16a/16b. The defect at position B' is a short-circuit 17b between the wiring strips 16a and 16b. The defect at position C' is a projection 17c on the wiring strip 16a, and the defect at position D' is a dust particle 17d under the wiring strip 16a. While the light beam LB10 is sweeping in a direction indicated by arrow AR2, the gray level is differently changed. The gray level is changed below "127" at position A', and is prolonged. Although the gray level is changed over "127" at position B', the gray level is prolonged. The peak below "127" and the peak over "127" on both sides of position C' make the projection 17c discriminative. The dust particle 17d under the wiring strip 16a has a different variation of gray level from that of the dust particle 17a over the wiring strips 16a/16b. The dust particle 17d has the peak below "127", and the wiring strip 16a over the dust particle 17d has the peak over "127". For this reason, the peaks below "127" and the peaks over "127" take place around position D'. Thus, the defects 17a to 17d have different variations of gray level, and the image processor 12i specifies the defects 17a to 17d into different defective modes, respectively.

The present inventor evaluated the automatic visual inspection system. The non-categorized defects were of the order of 5 percent, and most of the defects were automatically categorized into the defect modes. A semiconductor wafer contained a hundred defects, and an operator categorized each of the remaining five defects within 3 seconds. Time for the automatic categorizing operation on the remaining defects was negligible, and the visual inspection was completed within 15 seconds. When the operator categorized the hundred defects, he required five minutes for the visual inspection. As described in conjunction with step SP6, a new kind of variation of ray level was added to the inspection file, and the non-categorized defects were finally decreased to zero. Thus, the automatic visual inspection system according to the present invention accelerated the visual inspection.

### Second Embodiment

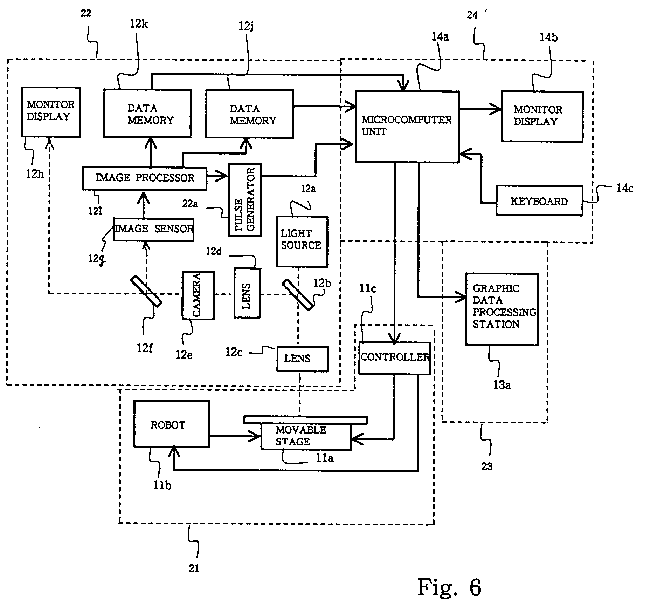

Turning to figure 6 of the drawings, another automatic visual inspection system embodying the present invention also comprises a loading sub-system 21, an image data generating/processing sub-system 22, a data analyzing sub-system 23 and a controlling sub-system 24. The loading sub-system 21, the data analyzing sub-system 23 and the controlling sub-system 24 are similar to those of the first embodiment, and components of these sub-systems 21, 23 and 24 are labeled with references designating corresponding components of the sub-systems 11, 13 and 14 without detailed description for the sake of simplicity.

A pulse generator 22a is added to the image data generating/processing sub-system 22. The other components of the image data generating/processing sub-system 22 are corresponding to the components of the image data generating/processing sub-system 12, and, for this reason, the other components are labeled with the same references as those of the image data generating/processing sub-system 12.

Description is focused on the pulse generator 22a. The pulse generator 22a reads out parts of distribution of gray level representative of defects, and converts the parts of distribution of gray level to pulse trains, respectively. The pulse trains are supplied to the microcomputer unit 14a, and the microcomputer unit 14a counts the pulses. The number of pulses is equivalent to the magnitude of the defect. The pulse width is much smaller than the pixel width, and, for this reason, the resolution is higher than that of the prior art automatic visual inspection system.

The automatic visual inspection system implementing the second embodiment achieves all the advantages of the first embodiment. The automatic visual inspection system implementing the second embodiment further achieves a high resolution of defects.

Although particular embodiments of the present invention have been shown and described, it will be obvious to those skilled in the art that various changes and modifications may be made without departing from the spirit and scope of the present invention.

For example, the light beam LB10 is deflected so as to sweep the predetermined area without the movable stage 11a, and, for this reason, the loading sub-system is not an indispensable element of the present invention.

The analyzing sub-system may be implemented by a software executed by the microcomputer unit 14a, and is not an indispensable element of the present invention.

The image generating/processing sub-system may determine the magnitude of defect so as to supply a digital data code representative of the magnitude to the microcomputer system 14a.

The microcomputer unit 14a may be implemented by a microprocessor accompanied with a program memory and a data memory.

## Claims

1. An automatic visual inspection system for visually inspecting an appearance of a target layer (WF) comprising:
an image data generating/processing sub-system (12/22) radiating a light beam (LB10) for sweeping said target layer for producing pieces of image data representative of said appearance and determining a location of a defect (17a/17b/17c/17d) contained in said target layer; and
a controlling sub-system (14/24) connected to said image data generating/processing sub-system, causing said light beam radiated from said controlling sub-system to sweep said target layer, and providing a piece of defect information representative of said location of said defect to an operator,
characterized in that
said image data generating/ processing sub-system categorizes said defect to one of defect modes, and said controlling sub-system further provides another piece of defect information representative of said one of said defect modes.

2. The automatic visual inspection system as set forth in claim 1, in which said image data generating/processing sub-system (12; 22) stores thresholds for producing a distribution of gray level and variations of gray level respectively representative of said defect modes, and compares said pieces of image data with said threshold for producing a distribution of gray level representative of said appearance containing said defect,
said image data generating/processing sub-system (12; 22) further compares parts of said distribution of gray level with said variations of gray level so as to categorize said defect to said one of said defect modes.

3. The automatic visual inspection system as set forth in claim 2, in which said image data generating/processing sub-system (22) includes a pulse generator (22a) for converting one of said parts of said distribution representative of said defect to a pulse train representative of a magnitude of said defect.

4. The automatic visual inspection system as set forth in claim 3, in which said controlling sub-system (24) includes a data processing unit (14a), and said pulse train is transferred from said image data generating/processing sub-system (22) to said controlling sub-system (24) so that said data processing unit (14a) determines the magnitude of said defect on the basis of a number of pulses contained in said pulse train.

5. The automatic visual inspection system as set forth in claim 1, in which said image data generating/processing sub-system (12; 22) includes a monitor display (12h) for projecting an image of said defect on a screen thereof, and
said controlling sub-system (14; 24) further includes an interface (14b/14c) between said data processing unit (14a) and said operator so that said operator categorizes said defect into said one of said defect modes when said image data generating/processing sub-system can not specify said one of said defect modes,
a variation of gray level representative of said defect categorized by said operator being transferred to said image data generating/processing sub-system (12; 22) so as to add said variation of gray level to an inspection file containing said variations of gray level.

6. The automatic visual inspection system as set forth in claim 1, further comprising
a loading sub-system (11; 21) having a movable stage (11a) for supporting said target layer (WF),
said controlling sub-system (14; 24) causing said light beam (LB10) to sweep said target layer by moving said movable stage.

7. The automatic visual inspection system as set forth in claim 1, further comprising an analyzing sub-system (13; 23) connected to said controlling sub-system for producing at least one of graphs and a map representative of said defect in said target layer on the basis of said location of said defect and said one of said defect modes.

8. The automatic visual inspection system as set forth in claim 1, in which said target layer is a semiconductor wafer (WF) after completion of a fabrication process for a semiconductor device.
